# EUROPEAN PATENT APPLICATION

(11) **EP 4 797 585 A1**
(43) Date of publication of application: **26.08.2026**
(21) Application number: 24890579.6
(22) Date of filing: 08.11.2024
(51) Int. Cl.: H04L 1/00

(54) **COMMUNICATION METHOD AND COMMUNICATION APPARATUS**

(30) Priority: 15.11.2023 CN 202311535036
(71) Applicant: HUAWEI TECHNOLOGIES CO., LTD., Shenzhen 518129 (CN)
(72) Inventor: QIN, Kangjian, Shenzhen, Guangdong 518129 (CN); ZHANG, Huazi, Shenzhen, Guangdong 518129 (CN); LIU, Ke, Shenzhen, Guangdong 518129 (CN); WANG, Xianbin, Shenzhen, Guangdong 518129 (CN); TONG, Jiajie, Shenzhen, Guangdong 518129 (CN); WANG, Jun, Shenzhen, Guangdong 518129 (CN)
(74) Representative: Goddar, Heinz J.
(86) International application number: PCT/CN2024/130795
(87) International publication number: WO 2025/103223

(57) **Abstract**

Embodiments of this application disclose a communication method and a communication apparatus in the field of communication technologies to meet transmission requirements in high throughput scenarios. The method includes: determining a physical channel in a first scenario, where a throughput of the first scenario is greater than a preset threshold; and transmitting data using a single codeword when a quantity of transmission layers of the physical channel is greater than a preset quantity of layers.

## Description

This application claims priority to Chinese Patent Application No. 202311535036.5, filed with the China National Intellectual Property Administration on November 15, 2023 and entitled "COMMUNICATION METHOD AND COMMUNICATION APPARATUS", which is incorporated herein by reference in its entirety.

### TECHNICAL FIELD

This application relates to the communication field, and in particular, to a communication method and a communication apparatus.

### BACKGROUND

With the development of communication technologies, users are demanding ever-higher data transmission efficiency and lower latency. During data transmission, a terminal device and a network device may communicate over physical channels. Each physical channel corresponds to a specific group of time-frequency resources and is used to carry transport channels and control information mapped from higher layers.

However, in some scenarios, such as a scenario involving high throughput, the peak data throughput between the terminal device and the network device can be significantly high. In such cases, the physical channels defined in existing protocols can no longer meet data transmission requirements.

### SUMMARY

Embodiments of this application provide a communication method and a communication apparatus to meet transmission requirements in high throughput scenarios.

According to a first aspect, a communication method is provided. The method includes: A transmitter determines a physical channel in a first scenario, where a throughput of the first scenario is greater than a preset threshold; and transmitting data using a single codeword when a quantity of transmission layers of the physical channel in the first scenario is greater than a preset quantity of layers.

Based on the technical solutions of this application, in a scenario with a high throughput, if a quantity of transmission layers of a physical channel in the scenario is greater than the preset quantity of layers, the transmitter may transmit data in the form of the single codeword. In this way, a throughput of a system can be improved, and transmission requirements in high throughput scenarios can be met.

In some examples, the preset quantity of layers may be 4.

In some examples, in the first scenario, the physical channel is used to transmit data whose coding parameter is greater than a preset threshold. For example, an amount of data transmitted in one slot of a single carrier of the physical channel is greater than two transport blocks (transport block, TB).

In a possible implementation, after determining a transport channel for data, the transmitter may determine a physical channel of the transport channel based on a first preset mapping relationship. In this way, the transmitter may quickly determine the physical channel in the first scenario based on a mapping between the physical channel and the transport channel.

In some embodiments, the physical channel in the first scenario includes an uplink physical channel and a downlink physical channel. The first preset mapping relationship may include a first mapping relationship and a second mapping relationship. The first mapping relationship includes mappings between a plurality of uplink transport channels and a plurality of uplink physical channels, and the second mapping relationship includes mappings between a plurality of downlink transport channels and a plurality of downlink physical channels.

In another possible implementation, after determining control information of the physical channel, the transmitter may determine, based on a second preset mapping relationship, the physical channel corresponding to the control information. The second preset mapping relationship may include a third mapping relationship and a fourth mapping relationship, the third mapping relationship includes mappings between a plurality of pieces of uplink control information and a plurality of uplink physical channels, and the fourth mapping relationship includes mappings between a plurality of pieces of downlink control information and a plurality of downlink physical channels. In this way, the transmitter may quickly determine the physical channel in the first scenario based on a mapping between the physical channel and the control information.

In some examples, a coding parameter of the physical channel in the first scenario includes one or more of the following: a channel coding scheme for data and/or control information, a base graph (base graph, BG) parameter, a parameter of a modulation scheme, a code length parameter, a retransmission parameter, and an interleaver parameter. The channel coding scheme includes a polar (Polar) coding scheme and an LDPC coding scheme. The base graph includes a first base graph and a second base graph, and the first base graph and the second base graph have different core parity-check columns. The modulation scheme includes MLC and BICM. The code length parameter includes a maximum coding length and a minimum coding length. A quantity of retransmission times includes a maximum quantity of retransmission times and a corresponding retransmission start point. The interleaver parameter includes an indicator indicating whether to perform bit interleaving.

In a possible implementation, the channel coding scheme may be determined based on a code length of the data. For example, when the code length of the data is greater than or equal to a preset code length, the channel coding scheme is the polar coding scheme; and when the code length of the data is less than the preset code length, the channel coding scheme is the LDPC coding scheme. For another example, when the code length of the data is greater than the preset code length, the channel coding scheme is the polar coding scheme; and when the code length of the data is less than or equal to the preset code length, the channel coding scheme is the LDPC coding scheme.

In some examples, a channel coding scheme corresponding to the transport channel for the data includes the polar coding scheme and the LDPC coding scheme. A channel coding scheme corresponding to the control information is the polar coding scheme.

In some examples, a value range of Zc in the LDPC coding scheme is a subset of a preset matrix lifting set or a preset subset.

A value in the preset subset is a positive integer multiple of 23, and a maximum value in the preset subset is greater than 384. An element in the preset matrix lifting set is aⱼ×2^{k}ⱼ, where aⱼ∈{2, 3, 5, 7, 9, 11, 13, 15}, and kⱼ∈{4, 5, 6, 7}.

In a possible implementation, the channel coding scheme is the LDPC coding scheme, and the method further includes: The transmitter skips performing row-column interleaving on a codeword of the data.

Based on this implementation, when the channel coding scheme for the physical channel is the LDPC coding scheme, the transmitter may not perform the row-column interleaving operation on the codeword of the data, to implement high throughput decoding. In addition, if row-column interleaving is not performed at a high code rate, protection performance of the system is not greatly affected.

In some examples, the base graph parameter includes a quantity of punctured columns of a core parity-check matrix of the base graph and/or a code rate obtained after column puncturing is performed on the core parity-check matrix.

A quantity of punctured columns of a core parity-check matrix of the first base graph is greater than 1, and a 1^{st} column of the first base graph is not punctured. A code rate obtained after puncturing is performed on a core parity-check matrix of the second base graph is greater than a preset code rate.

In some examples, elements in a 1^{st} row of the core parity-check matrix of the second base graph are elements in a 2^{nd} row of the core parity-check matrix of the first base graph, and elements in a 2^{nd} row of the core parity-check matrix of the second base graph are elements in a 1^{st} row of the core parity-check matrix of the first base graph.

In a possible implementation, the method may further include: The transmitter sends first indication information indicating to remove an edge of the base graph. For example, the first indication information may indicate a row number and a column number of the removed edge in the base graph. In this way, based on the indication information, the receiver can accurately determine to remove the edge of the base graph.

In a possible implementation, after determining a modulation scheme for the physical channel, the transmitter may determine, based on a third preset mapping relationship, a modulation parameter corresponding to the physical channel.

The third preset mapping relationship includes indexes of a plurality of modulation schemes and a modulation parameter corresponding to each index.

In a possible implementation, the transmitter may determine the modulation scheme for the physical channel based on a carrier frequency of the data. For example, when the carrier frequency of the data is greater than or equal to a preset frequency, the modulation scheme is MLC; and when the carrier frequency of the data is less than the preset frequency, the modulation scheme is BICM. For another example, when the carrier frequency of the data is greater than the preset frequency, the modulation scheme is MLC; and when the carrier frequency of the data is less than or equal to the preset frequency, the modulation scheme is BICM.

In some examples, the modulation parameter of the modulation scheme includes one or more of the following: a modulation order, a code rate, and frequency utilization efficiency. To support the high throughput scenarios, one modulation parameter in the third preset mapping relationship includes a modulation order of 6, a code rate of 973, and spectral efficiency of 5.7012.

In a possible implementation, the transmitter sends second indication information, where the second indication information indicates the coding parameter of the physical channel. For example, the second indication information may indicate one or more of the following: a channel coding scheme, a modulation scheme, whether retransmission is supported, and whether row-column interleaving is performed.

According to a second aspect, a communication method is provided. The method includes: A receiver receives data from a transmitter, and demodulates the received data to obtain demodulated data. The receiver performs channel decoding on the demodulated data to obtain original data.

In some examples, the data is transmitted using a single codeword.

In some examples, a quantity of transmission layers of a physical channel corresponding to a transport channel for transmitting the data is greater than a preset quantity of layers. For example, there are four layers.

In some examples, the physical channel is used to transmit data whose coding parameter is greater than a preset threshold. For example, an amount of data transmitted in one slot of a single carrier of the physical channel is greater than two TBs.

In a possible implementation, the receiver may further determine a coding parameter of the physical channel, and perform channel decoding on the demodulated data based on the coding parameter of the physical channel.

In some examples, the coding parameter of the physical channel includes one or more of the following: a channel coding scheme for the data and/or control information, a base graph parameter, a parameter of a modulation scheme, a code length parameter, a retransmission parameter, and an interleaver parameter. The channel coding scheme includes a polar coding scheme and an LDPC coding scheme. The base graph includes a first base graph and a second base graph, and the first base graph and the second base graph have different core parity-check columns. The modulation scheme includes MLC and BICM. The code length parameter includes a maximum coding length and a minimum coding length. A quantity of retransmission times includes a maximum quantity of retransmission times and a corresponding retransmission start point. The interleaver parameter includes an indicator indicating whether to perform bit interleaving.

In a possible implementation, the channel coding scheme may be determined based on a code length of the demodulated data. For example, when the code length of the data is greater than or equal to a preset code length, the channel coding scheme is the polar coding scheme; and when the code length of the data is less than the preset code length, the channel coding scheme is the LDPC coding scheme. For another example, when the code length of the data is greater than the preset code length, the channel coding scheme is the polar coding scheme; and when the code length of the data is less than or equal to the preset code length, the channel coding scheme is the LDPC coding scheme.

In some examples, a channel coding scheme corresponding to the transport channel for the data includes the polar coding scheme and the LDPC coding scheme. A channel coding scheme corresponding to the control information is the polar coding scheme.

In some examples, a value range of Zc in the LDPC coding scheme is a subset of a preset matrix lifting set or a preset subset.

A value in the preset subset is a positive integer multiple of 23, and a maximum value in the preset subset is greater than 384. An element in the preset matrix lifting set is aⱼ×2^{k}ⱼ, where aⱼ∈{2, 3, 5, 7, 9, 11, 13, 15}, and kⱼ∈{4, 5, 6, 7}.

In a possible implementation, the channel coding scheme is the LDPC coding scheme, and the method further includes: The receiver skips performing row-column interleaving on a codeword of the data.

In some examples, the base graph parameter includes a quantity of punctured columns of a core parity-check matrix of the base graph and/or a code rate obtained after column puncturing is performed on the core parity-check matrix.

A quantity of punctured columns of a core parity-check matrix of the first base graph is greater than 1, and a 1^{st} column of the first base graph is not punctured. A code rate obtained after puncturing is performed on a core parity-check matrix of the second base graph is greater than a preset code rate.

In some examples, elements in a 1^{st} row of the core parity-check matrix of the second base graph are elements in a 2^{nd} row of the core parity-check matrix of the first base graph, and elements in a 2^{nd} row of the core parity-check matrix of the second base graph are elements in a 1^{st} row of the core parity-check matrix of the first base graph.

In a possible implementation, the method may further include: The receiver receives, from the transmitter, first indication information indicating to remove an edge of the base graph. For example, the first indication information may indicate a row number and a column number of the removed edge in the base graph. In this way, based on the first indication information, the receiver can accurately determine to remove the edge of the base graph, thereby improving a throughput of a system.

In some examples, the modulation parameter of the modulation scheme includes one or more of the following: a modulation order, a code rate, and frequency utilization efficiency. To support high throughput scenarios, one modulation parameter in the third preset mapping relationship includes a modulation order of 6, a code rate of 973, and spectral efficiency of 5.7012.

In a possible implementation, the receiver receives second indication information from the transmitter, where the second indication information indicates one or more of the following: a channel coding scheme, a modulation scheme, whether retransmission is supported, and whether row-column interleaving is performed. The receiver may determine the coding parameter of the physical channel based on the second indication information.

According to a third aspect, a communication apparatus is provided, and configured to implement the foregoing methods. The communication apparatus may be the transmitter in any one of the first aspect or the implementations of the first aspect, an apparatus having a function of the transmitter, or an apparatus included in the transmitter, for example, a chip. The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In some possible designs, the communication apparatus may include a processing module and a transceiver module. The transceiver module may also be referred to as a transceiver unit, and is configured to implement a sending function and/or a receiving function in any one of the foregoing aspects and the possible implementations of the foregoing aspects. The transceiver module may include a transceiver circuit, a transceiver machine, a transceiver, or a communication interface. The processing module may be configured to implement a processing function in any one of the foregoing aspects and any one of the possible implementations of the foregoing aspects.

In some possible designs, the transceiver module includes a sending module and a receiving module, respectively configured to implement the sending function and the receiving function in any one of the foregoing aspects and any one of the possible implementations of the foregoing aspects.

According to a fourth aspect, a communication apparatus is provided, and configured to implement the foregoing methods. The communication apparatus may be the receiver in any one of the first aspect or the implementations of the first aspect, an apparatus having a function of the receiver, or an apparatus included in the receiver, for example, a chip. The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In some possible designs, the communication apparatus may include a processing module and a transceiver module. The transceiver module may also be referred to as a transceiver unit, and is configured to implement a sending function and/or a receiving function in any one of the foregoing aspects and the possible implementations of the foregoing aspects. The transceiver module may include a transceiver circuit, a transceiver machine, a transceiver, or a communication interface. The processing module may be configured to implement a processing function in any one of the foregoing aspects and any one of the possible implementations of the foregoing aspects.

In some possible designs, the transceiver module includes a sending module and a receiving module, respectively configured to implement the sending function and the receiving function in any one of the foregoing aspects and any one of the possible implementations of the foregoing aspects.

According to a fifth aspect, a communication apparatus is provided, including at least one processor. The processor is configured to execute, via a logic circuit and/or through communication, a computer program or instructions stored in a memory, so that the communication apparatus performs the method according to any one of the foregoing aspects.

In a possible implementation, the communication apparatus further includes the memory. Optionally, the memory is integrated with the processor, or the memory may be independent of the processor.

In a possible implementation, the memory is independent of the communication apparatus.

In a possible implementation, the communication apparatus further includes a communication interface. The communication interface is configured to communicate with a module other than the communication apparatus.

The communication apparatus may be the transmitter in any one of the first aspect or the implementations of the first aspect, or an apparatus included in the transmitter, for example, a chip.

According to a sixth aspect, a communication apparatus is provided, including at least one processor. The processor is configured to execute, via a logic circuit and/or through communication, a computer program or instructions stored in a memory, so that the communication apparatus performs the method according to any one of the foregoing aspects.

In a possible implementation, the communication apparatus further includes a memory. Optionally, the memory is integrated with the processor, or the memory may be independent of the processor.

In a possible implementation, the memory is independent of the communication apparatus.

In a possible implementation, the communication apparatus further includes a communication interface. The communication interface is configured to communicate with a module other than the communication apparatus.

The communication apparatus may be the transmitter in any one of the second aspect or the implementations of the second aspect, or an apparatus included in the transmitter, for example, a chip.

According to a seventh aspect, a computer-readable storage medium is provided. The computer-readable storage medium stores a computer program or instructions. When the computer program or the instructions are run on a communication apparatus, the communication apparatus is enabled to perform the method according to any one of the foregoing aspects or the implementations of the foregoing aspects.

According to an eighth aspect, a computer program product including instructions is provided. When the computer program product runs on a communication apparatus, the communication apparatus is enabled to perform the method according to any one of the foregoing aspects or the implementations of the foregoing aspects.

According to a ninth aspect, a communication apparatus is provided (for example, the communication apparatus may be a chip or a chip system). The communication apparatus includes a processor, configured to implement a function in any one of the foregoing aspects or any one of the implementations of the foregoing aspects.

In some possible designs, the communication apparatus includes a memory, and the memory is configured to store necessary program instructions and data.

In some possible designs, when the apparatus is a chip system, the apparatus may include a chip, or may include a chip and another discrete component.

It may be understood that, when the communication apparatus provided in any one of the third aspect to the ninth aspect is a chip, the foregoing sending action/function may be understood as an output, and the receiving action/function may be understood as an input.

For technical effect brought by any design manner in the second aspect to the ninth aspect, refer to technical effect brought by different design manners in the first aspect. Details are not described herein again.

According to a tenth aspect, a communication system is provided. The communication system includes a transmitter and a receiver. The transmitter may perform the method according to any one of the first aspect or the implementations of the first aspect, and the receiver may perform the method according to any one of the second aspect or the implementations of the second aspect.

### BRIEF DESCRIPTION OF DRAWINGS

FIG. 1 is a diagram of a data transmission process according to an embodiment of this application;
FIG. 2 is a diagram of an architecture of a communication system according to an embodiment of this application;
FIG. 3 is a diagram of a structure of a communication apparatus according to an embodiment of this application;
FIG. 4 is a schematic flowchart of a communication method according to an embodiment of this application;
FIG. 5 is a diagram of a core parity-check matrix of a base graph according to an embodiment of this application;
FIG. 6 is a diagram of a structure of indication information according to an embodiment of this application;
FIG. 7 is a diagram of a structure of a transmitter 700 according to an embodiment of this application; and
FIG. 8 is a diagram of a structure of a receiver 800 according to an embodiment of this application.

### DESCRIPTION OF EMBODIMENTS

For ease of understanding of embodiments of this application, the following descriptions are provided before embodiments of this application are described.
1. In embodiments of this application, a "network element" and a "node" may be logical entities or physical entities. In other words, in embodiments of this application, an "apparatus" and the "network element" may be replaced for description. This is uniformly described herein, and details are not described below again.
2. In embodiments of this application, for ease of description, numbers or indexes may be consecutively numbered from 1, may be consecutively numbered from 0, or may be numbered from any parameter.
3. "Predefinition", "preconfiguration", or "agreement in a protocol" may be implemented by pre-storing corresponding code or a corresponding table in a device (for example, a network device or a terminal device), or in another manner that may indicate related information. A specific implementation of "predefinition", "preconfiguration", or "agreement in a protocol" is not limited in embodiments of this application. "Storage" may be storage in one or more memories.
4. A "protocol" in embodiments of this application may be a standard protocol in the communication field, for example, may include a long term evolution (long term evolution, LTE) protocol, a new radio NR protocol, and a related protocol applied to a future communication system (for example, a 6th generation (6th generation, 6G) communication system). This is not limited in embodiments of this application.
5. In embodiments of this application, descriptions such as "when...", "in a case of...", and "if" all mean that a device performs corresponding processing in an objective case, and are not limited to time, and the device is not required to perform a determining action during implementation. This does not mean that there is another limitation.
6. In embodiments of this application, "sending information to... (a receiver)" may be understood as that a destination end of the information is the receiver, and may include directly or indirectly sending information to the receiver. "Receiving information from... (a transmitter)" or "receiving information from... (a transmitter)" may be understood as that a source end of the information is the transmitter, and may include directly or indirectly receiving information from the transmitter. Information may undergo necessary processing, for example, a format change, between a source end for sending the information and a destination end. However, the destination end may understand valid information from the source end. Similar expressions in this application may be understood similarly, and details are not described herein again.
7. In the descriptions of embodiments of this application, unless otherwise specified, "and/or" in embodiments of this application indicates that three relationships may exist. For example, A and/or B may indicate the following three cases: Only A exists, both A and B exist, and only B exists, where A and B may be singular or plural. In addition, "at least one of the following" or a similar expression thereof indicates any combination of these items, including a single item or any combination of a plurality of items. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to give an example, an illustration, or a description.

With continuous development of communication technologies, increasing scenarios are newly defined in a communication protocol standard. For example, Release 12 of the 3rd generation partnership project (3rd generation partnership project, 3GPP) does not define narrowband Internet of Things (narrowband internet of things, NB-IoT), and this feature is reflected in a newly introduced chapter Narrowband IoT in Release 13.

For another example, Release 15 defines six types of physical channels, five types of transport channels, and two types of control information. Some physical channels correspond only to control information, and do not correspond to transport channels. Release 16 defines a sidelink transport channel and control information (sidelink transport channel and control information) for a sidelink (sidelink) scenario, and specifically defines four new types of physical channels, two new types of transport channels, and three new types of control information.

Generally, after a concept is defined for a new scenario in a communication protocol standard, a new transport channel and new control information are not necessarily defined, but a new physical channel related to the scenario is defined. However, for a physical channel in high throughput scenarios, a current communication protocol standard is not defined.

A high throughput (high throughput) scenario may also be referred to as a first scenario, a high transmission scenario, an enhanced mobile broadband (enhanced mobile broadband, eMBB)+ scenario, or another naming manner. This is not limited. For ease of description below, these scenarios are collectively referred to as high throughput scenarios.

In comparison with a scenario like eMBB or NB-IoT, in the high throughput scenarios, a throughput (which may also be referred to as a data throughput, a peak data rate, a peak throughput, or another name) is greater than a preset threshold, for example, greater than 200 Gbit/s. It can be learned that more physical time domain resources and more antenna ports may be required in the high throughput scenarios. The peak data rate is a maximum attainable data rate of user equipment in an ideal condition. For example, in the high throughput scenarios, an amount of data transmitted in one slot of one single carrier of a physical channel may be greater than two TBs. However, in an existing communication protocol, a coding chain (for example, a physical channel or control information) in the high throughput scenarios is not defined for design.

The physical channel corresponds to a group of specific time-frequency resources, and is used to carry a transport channel and control information that are mapped by a higher layer. Generally, a maximum quantity of codewords supported by an NR system is 2, that is, data of a maximum of two TBs is sent in one slot of a single carrier. When a quantity of transmission layers of an existing physical channel is greater than 4, a payload needs to be encoded into two codewords for transmission, and transmission at more than four transmission layers through one long code is not supported. In other words, data transmission in high throughput scenarios is not supported. A maximum code rate indicated by existing control information is 948/1024, and cannot support a code rate at a high throughput rate. Therefore, new control information needs to be defined for the high throughput scenarios.

In addition, in the communication protocol standard, a mapping between a transport channel (transport channel, TrCH) and a channel coding scheme (coding scheme) may be shown in Table 1, and a mapping between control information (control information) and a channel coding scheme may be shown in Table 2. The transport channel may include an uplink shared channel (uplink shared channel, UL-SCH), a downlink shared channel (downlink shared channel, DL-SCH), a paging channel (paging channel, PCH), a broadcast channel (broadcast channel, BCH) BCH, and the like. The control information may include uplink control information (downlink control information, DCI), uplink control information (uplink control information, UCI), and the like. The channel coding scheme may include a low-density parity-check (low-density parity-check, LDPC) coding scheme (which may also be referred to as an LDPC code), a block code (Block code) coding scheme, a polar code (Polar code) coding scheme (which may also be referred to as a polar code), and the like.

**Table 1**

| Transport channel | Channel coding scheme |
|---|---|
| UL-SCH | LDPC coding scheme |
| DL-SCH | |
| PCH | |
| BCH | Polar coding scheme |

It can be learned from Table 1 that channel coding schemes corresponding to the UL-SCH, the DL-SCH, and the PCH may be the LDPC coding scheme, and a channel coding scheme corresponding to the BCH may be the Polar coding scheme.

**Table 2**

| Control information | Channel coding scheme |
|---|---|
| DCI | Polar coding scheme |
| UCI | Block coding scheme |
| | Polar coding scheme |

It can be learned from Table 2 that a channel coding scheme corresponding to the DCI may be the polar coding scheme, and a channel coding scheme corresponding to the UCI may include the polar coding scheme and the block coding scheme.

In view of this, embodiments of this application provide a channel coding scheme, to support data transmission in high throughput scenarios. The channel coding scheme may include designing a new physical channel, a related coding parameter, control information, and the like.

The channel coding scheme in embodiments of this application may be applied to a dedicated network device, a general-purpose device, a base station device, a terminal device, and the like. The terminal device may include a smartphone, a tablet computer (PAD), a vehicle-mounted mobile apparatus, a personal digital assistant (personal digital assistant, PDA), a wearable device, a virtual reality (virtual reality, VR) terminal device, an augmented reality (augmented reality, AR) terminal device, an internet of things device, and the like.

The technical solutions in embodiments of this application may be implemented through a chip (for example, a dedicated chip ASIC or a programmable chip FPGA), or may be implemented through software (for example, program code in a memory).

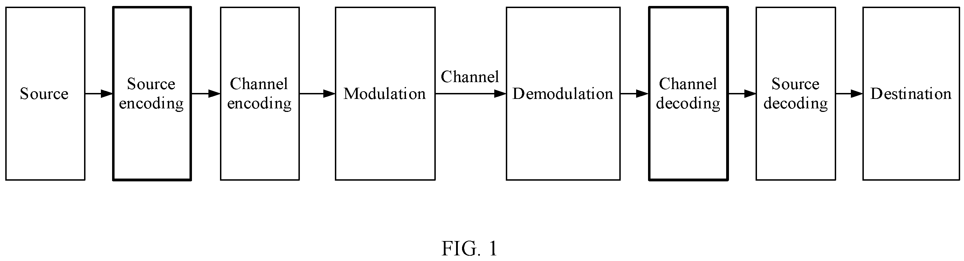

FIG. 1 is a diagram of a data transmission process according to an embodiment of this application. A data transmission process may include source encoding, channel encoding, modulation, demodulation, channel decoding, source decoding, and the like.

Channel encoding is used to perform channel encoding on an information bit generated by a source. Channel decoding is used to restore a received encoded information bit to an information bit stream of the source.

In some embodiments, a transmitter may encode, through source encoding, an information bit generated by a source. After obtaining the encoded information bit, the transmitter may perform channel encoding and modulation on the encoded information bit through channel encoding, to obtain a modulation symbol. Then, the transmitter may send the modulation symbol to a receiver through a noisy channel. After receiving the modulation symbol from the transmitter, the receiver performs demodulation to obtain the encoded information bit, and performs channel decoding and source decoding on the encoded information bit to obtain an information bit required by a destination.

In some embodiments, with reference to FIG. 1, after performing channel decoding on data, the transmitter may further perform an interleaving operation (or row-column interleaving) on the data. Correspondingly, after demodulating the received data, the receiver may perform a de-interleaving operation, and perform channel decoding on the de-interleaved data.

The technical solutions in embodiments of this application may be applied to phases of channel encoding and channel decoding in FIG. 1.

In some implementations, the transmitter may be configured with a channel decoding unit, configured to perform the foregoing channel encoding. A channel decoding unit is configured at the receiver, and is configured to perform the channel decoding.

The technical solutions in embodiments of this application may be applied to a wireless communication system. The wireless communication system includes but is not limited to 5G, satellite communication, NB-IoT, a global system for mobile communication (global system for mobile communication, GSM), an enhanced data rate GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronous code division multiple access (time division-synchronous code division multiple access, TD-SCDMA) system, a long term evolution (long term evolution, LTE) system, and three application scenarios eMBB, URLLC, and eMTC of a next-generation 5G mobile communication system.

The wireless communication system usually includes cells. Each cell includes a base station (base station, BS), and the base station provides a communication service for a plurality of mobile stations (mobile station, MS). The base station includes a baseband unit (baseband unit, BBU) and a remote radio unit (remote radio unit, RRU). The BBU and the RRU may be placed at different places. For example, the RRU is remote and placed in a heavy-traffic area, and the BBU is placed in a central equipment room. Alternatively, the BBU and the RRU may be placed in a same equipment room. Alternatively, the BBU and the RRU may be different components at a same rack.

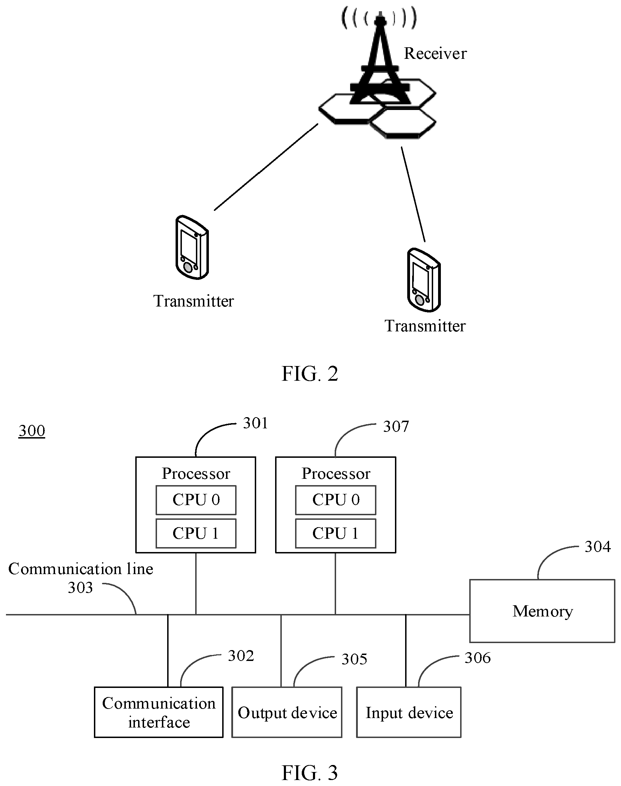

FIG. 2 shows a communication system according to an embodiment of this application. The communication system may include a transmitter and a receiver. The transmitter is in communication connection to the receiver.

In some scenarios, the transmitter in FIG. 2 may be a terminal device or a component (for example, a chip) in the terminal device, and the receiver may be a network device or a component (for example, a chip) in the network device. Alternatively, the transmitter may be a network device or a component in the network device, and the receiver may be a terminal device or a component in the terminal device.

The terminal device may also be referred to as a user terminal, a mobile station, or the like. The terminal device may be user equipment (user equipment, UE), an access terminal, a terminal unit, a user station, a terminal station, a mobile station, a mobile console, a remote station, a remote terminal, a user terminal (terminal equipment, TE), a mobile device, a wireless communication device, a terminal agent, a tablet computer (pad), a handheld device with a wireless communication function, a compute device, another processing device connected to a wireless modem, a vehicle-mounted device, a vehicle-mounted transceiver unit, a wearable device, or a terminal apparatus in a 5th generation (5th generation, 5G) mobile communication technology network or a public land mobile network (public land mobile network, PLMN) evolved after 5G. The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a compute device, another processing device connected to a wireless modem, a vehicle-mounted device, an unmanned aerial vehicle, a robot, a smart point of sale (point of sale, POS) machine, customer-premises equipment (customer-premises equipment, CPE), a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), or the like. Alternatively, the terminal device may be a terminal having a communication function in the internet of things (internet of things, IoT), for example, a terminal in V2X (for example, a vehicle to everything device), a terminal in D2D communication, or a terminal in M2M communication. The terminal device may be mobile.

A form of the terminal device is not limited in embodiments of this application. An apparatus for implementing a function of the terminal device may be a terminal device, or may be an apparatus, for example, a chip system, that can support the terminal device in implementing the function. The apparatus may be mounted in the terminal device or used in combination with the terminal device. In embodiments of this application, the chip system may include a chip, or may include a chip and another discrete component.

The network device may be used by the terminal device to perform communication. For example, the network device may include an evolved NodeB (NodeB or eNB or e-NodeB, evolutional NodeB) in an LTE system or an LTE-advanced (LTE-advanced, LTE-A) system, for example, a conventional macro base station eNB and a micro base station eNB in a heterogeneous network scenario. Alternatively, the network device may include a next generation NodeB (next generation NodeB, gNB) in the NR system. Alternatively, the network device may include a transmission reception point (transmission reception point, TRP), a home NodeB (for example, home evolved NodeB or home NodeB, HNB), a baseband unit (baseband unit, BBU), a baseband unit pool (BBU pool), a wireless fidelity (wireless fidelity, Wi-Fi) access point (access point, AP), and the like. Alternatively, the network device may include a base station in a non-terrestrial network (non-terrestrial network, NTN), that is, may be deployed on an airplane platform or a satellite. In the NTN, the network device may be used as a layer 1 (L1) relay (relay), may be used as a base station, or may be used as an integrated access and backhaul (integrated access and backhaul, IAB) node. Alternatively, the network device may be a device that is in IoT and that implements functions of a base station, for example, a device that is in uncrewed aerial vehicle communication, V2X, D2D, or machine-to-machine (machine-to-machine, M2M) and that implements the functions of the base station.

In some possible scenarios, the network device may alternatively be a module or unit that can implement some functions of a base station. For example, the network device may be a central unit (central unit, CU), a distributed unit (distributed unit, DU), a CU-control plane (control plane, CP), a CU-user plane (user plane, UP), or a radio unit (radio unit, RU). The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or a CU-CP and a CU-UP), the DU, or the RU may alternatively have different names, but a person skilled in the art may understand meanings thereof. For example, the network device may be a network device in an open radio access network (open RAN, ORAN) system or a module of the network device. In the ORAN system, the CU may also be referred to as an open (open, O)-CU, the DU may also be referred to as an O-DU, the CU-CP may also be referred to as an O-CU-CP, the CU-UP may also be referred to as an O-CU-UP, and the RU may also be referred to as an O-RU. Any one of the CU (or the CU-CP or the CU-UP), the DU, and the RU in this application may be implemented via a software module, a hardware module, or a combination of a software module and a hardware module.

Optionally, the base station in embodiments of this application may include various forms of base stations, for example, a macro base station, a micro base station (also referred to as a small cell), a relay station, an access point, a home base station, a TRP, a transmitting point (transmitting point, TP), or a mobile switching center. This is not specifically limited in embodiments of this application.

A form of the network device is not limited in embodiments of this application. An apparatus for implementing a function of the network device may be a network device, or may be an apparatus, for example, a chip system, that can support the network device in implementing the function. The apparatus may be mounted in the network device or used in combination with the network device.

It should be noted that FIG. 2 is an example of an accompanying drawing, and a quantity of devices shown in FIG. 2 and names of interfaces between the devices in FIG. 2 are not limited. In addition to the network elements shown in FIG. 2, the communication system shown in FIG. 2 may further include another device, for example, a network device. This is not limited.

During specific implementation, each device in FIG. 2 may use a composition structure shown in FIG. 3, or include components shown in FIG. 3. FIG. 3 is a diagram of composition of a communication apparatus 300 according to an embodiment of this application. The communication apparatus 300 may be a transmitter, or a chip or a system on chip in a transmitter. Alternatively, the communication apparatus 300 may be a receiver or a chip or a system on a chip in a receiver. As shown in FIG. 3, the communication apparatus 300 includes a processor 301, a communication interface 302, and a communication line 303.

Further, the communication apparatus 300 may further include a memory 304. The processor 301, the memory 304, and the communication interface 302 may be connected to each other through the communication line 303.

The processor 301 is a central processing unit (central processing unit, CPU), a general-purpose processor, a network processor (network processor, NP), a digital signal processor (digital signal processor, DSP), a microprocessor, a microcontroller, a programmable logic device (programmable logic device, PLD), or any combination thereof. Alternatively, the processor 301 may be another apparatus having a processing function, for example, a circuit, a component, or a software module. This is not limited.

The communication interface 302 is configured to communicate with another device or another communication network. The another communication network may be Ethernet, a radio access network (radio access network, RAN), a wireless local area network (wireless local area network, WLAN), or the like. The communication interface 302 may be a module, a circuit, a communication interface, or any apparatus that can implement communication.

The communication line 303 is configured to transmit information between components included in the communication apparatus 300.

The memory 304 is configured to store instructions. The instructions may be a computer program.

The memory 304 may be a read-only memory (read-only memory, ROM) or another type of static storage device that can store static information and/or instructions, or may be a random access memory (random access memory, RAM) or another type of dynamic storage device that can store information and/or instructions, or may be an electrically erasable programmable read-only memory (electrically erasable programmable read-only memory, EEPROM), a compact disc read-only memory (compact disc read-only memory, CD-ROM) or another compact disc storage, optical disc storage (including a compressed optical disc, a laser disc, an optical disc, a digital universal optical disc, a Blu-ray optical disc, and the like), magnetic disk storage medium or another magnetic storage device, or the like. This is not limited.

It should be noted that the memory 304 may exist independently of the processor 301, or may be integrated with the processor 301. The memory 304 may be configured to store instructions, program code, some data, or the like. The memory 304 may be located inside the communication apparatus 300, or may be located outside the communication apparatus 300. This is not limited. The processor 301 is configured to execute the instructions stored in the memory 304, to implement a data transmission method applied to short-range wireless communication provided in the following embodiments of this application.

In an example, the processor 301 may include one or more CPUs, for example, a CPU 0 and a CPU 1 in FIG. 3.

In an optional implementation, the communication apparatus 300 includes a plurality of processors. For example, in addition to the processor 301 in FIG. 3, the communication apparatus 300 may further include a processor 307.

In an optional implementation, the communication apparatus 300 further includes an output device 305 and an input device 306. For example, the input device 306 is a device, for example, a keyboard, a mouse, a microphone, or a joystick, and the output device 305 is a device, for example, a display or a speaker (speaker).

It should be noted that the communication apparatus 300 may be a desktop computer, a portable computer, a network server, a mobile phone, a tablet computer, a wireless terminal, an embedded device, a chip system, or a device having a similar structure in FIG. 3. In addition, the composition structure shown in FIG. 3 does not constitute a limitation on the transmitter and the receiver. In addition to the components shown in FIG. 3, the transmitter and the receiver may include more or fewer components than those shown in the figure, or a combination of a part of the components, or an arrangement of different components.

In embodiments of this application, the chip system may include a chip, or may include a chip and another discrete component.

In addition, actions, terms, and the like in embodiments of this application may be mutually referenced. This is not limited. In embodiments of this application, names of information exchanged between devices, names of parameters in the information, or the like are merely examples. During specific implementation, other names may alternatively be used. This is not limited. This embodiment of this application may be performed by a transmitter, or a component like a chip in the transmitter, or may be a receiver, or a component like a chip in the receiver.

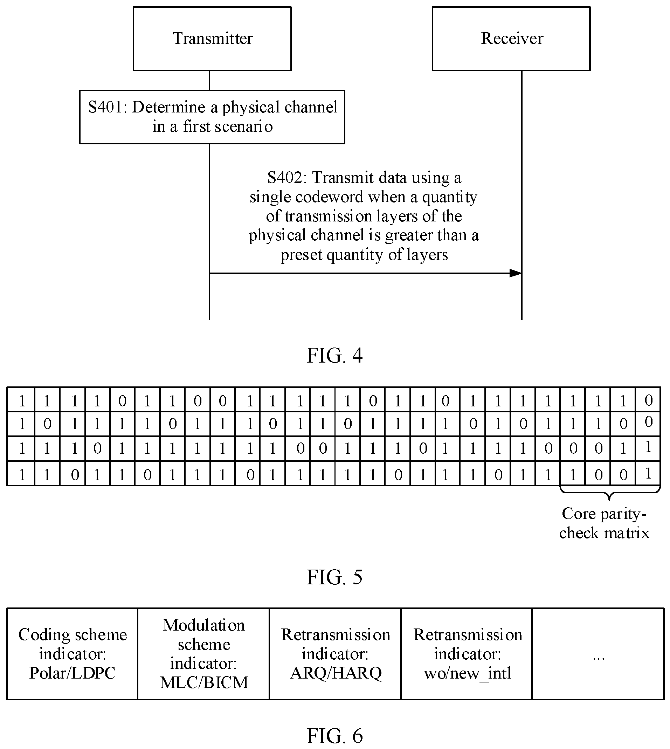

Based on the communication system shown in FIG. 2, FIG. 4 shows a communication method according to an embodiment of this application. The method includes S401 and S402.

S401: A transmitter determines a physical channel in a first scenario.

A throughput of the first scenario is greater than a preset threshold. For example, the first scenario may be the foregoing high throughput scenarios. A throughput that can be supported by the physical channel in the first scenario may be greater than the preset threshold, for example, may be greater than 200 Gbit/s. In this embodiment of this application, the physical channel (to distinguish from an existing physical channel, a physical channel supporting a high throughput is referred to as a high throughput physical channel for short) in the first scenario may include a high throughput physical shared channel, a high throughput random access channel, a high throughput broadcast channel, a high throughput physical control channel, and the like.

In an example, the high throughput physical shared channel may include a high throughput physical uplink shared channel (high throughput physical uplink shared channel, HTPUSCH)/physical high throughput uplink shared channel (physical high throughput uplink shared channel, PHTUSCH) and a high throughput physical downlink shared channel (high throughput physical downlink shared channel, HTPDSCH)/physical high throughput downlink shared channel (physical high throughput downlink shared channel, PHTDSCH).

The high throughput random access channel may include a high throughput physical random access channel (high throughput physical random access channel, HTPRACH)/physical high throughput random access channel (physical high throughput random access channel, PHTRACH).

The high throughput broadcast channel may include a high throughput physical broadcast channel (high throughput physical broadcast channel, HTPBCH)/physical high throughput broadcast channel (physical high throughput broadcast channel, PHTBCH).

The high throughput physical control channel may include a high throughput physical uplink control channel (high throughput physical uplink control channel, HTPUCCH)/physical high throughput uplink control channel (physical high throughput uplink control channel, PHTUCCH) and a high throughput physical downlink control channel (high throughput physical downlink control channel, HTPDCCH)/physical high throughput downlink control channel (physical high throughput downlink control channel, PHTDCCH).

In a possible implementation, the transmitter may determine the physical channel in the first scenario based on a transport channel for data. For example, a physical channel corresponding to the transport channel may be determined based on a mapping relationship (which may be referred to as a first preset mapping relationship) between the physical channel and the transport channel.

In an example, the physical channel includes an uplink physical channel and a downlink physical channel. The first preset mapping relationship may include a first mapping relationship and a second mapping relationship. The first mapping relationship may include mappings between a plurality of uplink transport channels and a plurality of uplink physical channels. The second mapping relationship may include mappings between a plurality of downlink transport channels and a plurality of downlink physical channels.

For example, the first mapping relationship may be shown in Table 3, and the second mapping relationship may be shown in Table 4. The plurality of uplink transport channels may include a UL-SCH and a RACH, and the plurality of downlink transport channels may include a DL-SCH, a BCH, and a PCH.

**Table 3**

| Uplink transport channel | Physical channel |
|---|---|
| UL-SCH | HTPUSCH/PHTUSCH |
| RACH | HTPRACH/PHTRACH |

**Table 4**

| Downlink transport channel | Physical channel |
|---|---|
| DL-SCH | HTPDSCH/PHTDSCH |
| BCH | HTPBCH/PHTBCH |
| PCH | HTPDSCH/PHTDSCH |

In another possible implementation, the transmitter may determine the physical channel in the first scenario based on control information of the physical channel. For example, the physical channel corresponding to the control information may be determined based on a mapping relationship (which may be referred to as a second preset mapping relationship) between the physical channel and the control information.

The second preset mapping relationship may include a third mapping relationship and a fourth mapping relationship. The third mapping relationship includes a mapping between uplink control information and the physical channel, and the fourth mapping relationship includes a mapping between downlink control information and the physical channel. For example, the second preset mapping relationship may be shown in Table 5. The control information may include uplink control information (uplink control information, UCI) and downlink control information (downlink control information, DCI).

**Table 5**

| Control information | Physical channel |
|---|---|
| UCI | HTPUCCH, HTPUSCH /PHTUCCH, PHTUSCH |
| DCI | HTPDCCH/PHTDCCH |

In Table 5, a 1^{st} row is the third mapping relationship, and a 2^{nd} row is the fourth mapping relationship.

S402: When a quantity of transmission layers of the physical channel is greater than a preset quantity of layers, the transmitter transmits data using a single codeword. Correspondingly, the receiver receives the data from the transmitter.

An amount of data transmitted in one slot of one single carrier used to carry data is greater than two TBs. For example, there may be three TBs, four TBs, or more TBs. This is not limited.

Further, after receiving the data, the receiver may demodulate the data to obtain demodulated data, and perform channel decoding on the demodulated data to obtain required original data. The original data is data initially generated by the transmitter, that is, data required by the receiver.

Based on the technical solution in FIG. 4, in this embodiment of this application, when the quantity of transmission layers of the physical channel used to transmit high throughput data is greater than the preset quantity of layers, one codeword may be used to transmit data. In this way, a throughput of data transmission can be improved, and data transmission requirements in high throughput scenarios can be met.

In some embodiments, with reference to FIG. 1, the transmitter may use a coding parameter to perform channel encoding on the data and/or the physical channel. In the first scenario, when the transmitter performs channel encoding on the data and/or the control information of the physical channel, the used coding parameter may include one or more of the following: a parameter of a channel coding scheme, a base graph parameter, a parameter of a modulation scheme, a code length parameter, a retransmission parameter, and an interleaver parameter. The following separately describes the coding parameters.

### 1. Parameter of the channel coding scheme

The channel coding scheme may include a polar coding scheme and an LDPC coding scheme. A value of the channel coding scheme may include Zc, which is a lifting factor.

In an example, the transmitter may determine the channel coding scheme for the physical channel based on a code length of data. For example, when the code length of the data is less than or equal to a preset code length, the channel coding scheme may be the polar coding scheme; and when the code length of the data is greater than the preset code length, the channel coding scheme may be the LDPC coding scheme. For another example, when the code length of the data is less than the preset code length, the channel coding scheme may be the polar coding scheme; and when the code length of the data is greater than or equal to the preset code length, the channel coding scheme may be the LDPC coding scheme. The preset code length may be set based on a requirement, for example, may be 1K or 1024bb. This is not limited.

In this embodiment of this application, the transmitter may determine the code length of the data based on a scenario in which the transmitter is located. For example, if the transmitter is in a short-range data transmission scenario (for example, an indoor scenario), it indicates that a code length of data transmitted by the transmitter is short. In this scenario, the transmitter may be a VR device or an AR device. If the transmitter is in a long-range data transmission scenario (for example, an outdoor scenario), it indicates that a code length of data transmitted by the transmitter is long. In this scenario, the transmitter is a mobile device that performs transmission through an air interface.

With reference to the foregoing channel coding scheme, in this embodiment of this application, in high throughput scenarios, a mapping between the transport channel for the data and the channel coding scheme may be shown in Table 6. The transport channel for the data includes a UL-SCH, a DL-SCH, a PCH, and an SCH.

**Table 6**

| Transport channel | Channel coding scheme |
|---|---|
| UL-SCH | LDPC coding scheme and Polar coding scheme |
| DL-SCH | |
| PCH | |
| BCH | Polar coding scheme |

In comparison with Table 1, in this embodiment of this application, when the first scenario is an indoor short-range scenario, the UL-SCH, the DL-SCH, and the PCH may be mapped to the polar coding scheme, which is more flexible.

To support high throughput scenarios, in this embodiment of this application, a mapping between the control information of the physical channel and the channel coding scheme may be shown in Table 7. The control information of the physical channel may include DCI and UCI.

**Table 7**

| Control information | Channel coding scheme |
|---|---|
| DCI | Polar coding scheme |
| UCI | |

In comparison with Table 2, in this embodiment of this application, the block coding scheme is deleted from the channel coding scheme corresponding to the control information. In other words, in the high throughput scenarios, the polar coding scheme is used as the channel coding scheme for the control information of the physical channel. This simplifies a protocol procedure and improves a throughput of a system. In addition, an area of a decoder at the receiver can be further reduced, thereby reducing costs.

The following describes a value of the channel coding scheme.

A value range of Zc of the channel coding scheme may be a subset of a preset matrix lifting size (lifting size) set or a preset subset.

In an example, an element in the preset lifting size set may be aⱼ×2^{k}ⱼ, where aⱼ∈{2, 3, 5, 7, 9, 11, 13, 15}, and kⱼ∈{7, 7, 6, 5, 5, 5, 4, 4}. For example, the preset lifting size set may be shown in Table 8.

**Table 8**

| Set index (index) | Set of lifting sizes (Z) |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

In another example, the channel coding scheme is the LDPC coding scheme, and the preset subset may be determined based on a prime number base supported by the base graph. For example, the preset subset may include a minimum value in an intersection set of a prime number base supported by a base graph 1 and a prime number base supported by a base graph 2. The base graph 1 and the base graph 2 are base graphs in the conventional technology.

In an example, the prime number base supported by the base graph 1 may be {23, 29, 31, 37, 41}. The prime number base supported by the base graph 2 may be {11, 13, 17, 19, 23}. That is, the preset subset may include 23.

In a possible implementation, Zc of the channel coding scheme is a subset in the preset lifting size set. With reference to Table 8, a value range of Zc of the channel coding scheme may be a larger value in each row of elements. For example, a value range of Zc may be the element aⱼ×2^{k}ⱼ in Table 8, where aⱼ∈{2, 3, 5, 7, 9, 11, 13, 15}, and kⱼ∈{4, 5, 6, 7}.

In another possible implementation, Zc of the channel coding scheme is a preset subset. With reference to Table 8, the preset subset may be a subset including a maximum value of an element in the preset lifting size set. The preset subset may include a maximum value in each row of elements. For example, a value range of Zc may be {256, 384, 320, 224, 288, 352, 208, 240}.

In another example, Zc of the channel coding scheme is a preset subset. The preset subset may be a newly added subset.

In a possible implementation, as shown in Table 9, the preset subset may be a lifting size newly added based on Table 8. The newly added lifting size may include a plurality of elements, each element may be a positive integer multiple of 23, and a maximum value in the preset subset is greater than 384. In Table 9, t is a positive integer.

**Table 9**

| Set index | Set of lifting sizes (Z) |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |
| 8 | {23, 46, 69, 92, 115, 138, 161, 184, ..., 23*t} |

In some scenarios, the transmitter and the receiver may preconfigure a third preset relationship. For example, the third preset mapping relationship may be stored in a form of a table (that is, an MSC table). After obtaining a modulation parameter for the physical channel, the transmitter may determine, based on the third preset mapping relationship, an index value corresponding to the modulation parameter, and send the index value to the receiver. In this way, the receiver can accurately determine the modulation parameter for the physical channel based on the index value.

### 2. Base graph parameter

The base graph may include a first base graph and a second base graph, which have different core parity-check columns. The base graph parameter may include a quantity of punctured columns in the core parity-check column of the base graph, a code rate of the punctured column, and the like.

In an example, when LDPC is used as the channel coding scheme, the first base graph may be the base graph 1, and the second base graph may be a new base graph.

In a possible implementation, due to the high code rate in high throughput scenarios, two columns of core parity-check columns in the base graph need to be punctured from the end to the beginning.Typically, the first two columns in the base graph also need to be punctured, resulting in two punctured columns in a 2^{nd} row. This means that the 2^{nd} row of the base graph will always pass the parity check, making decoding impossible. To avoid this issue, elements in a 1^{st} row and elements in a 2^{nd} row of the core parity-check matrix of the base graph may be swapped.

Based on this implementation, when the first base graph is the base graph 1, swapping elements in a 1^{st} row and elements in a 2^{nd} row of a core parity-check matrix of the base graph 1 yields a core parity-check matrix of the second base graph. An example of the core parity-check matrix of the second base graph is shown in FIG. 5.

In another possible implementation, to support transmission in the high throughput scenarios, a code rate of a punctured column in the core parity matrices of the first base graph and the second base graph may be higher than a preset code rate. The preset code rate may be set as needed, for example, 0.95. This is not limited.

Further, to increase the code rate in the high throughput scenarios, a new information column may be added to the second base graph. The code rate of the newly added information column is higher than 0.95. The 1^{st} column in the first base graph and the 1^{st} column in the second base graph may not be punctured.

In some examples, a quantity of punctured columns of the core parity-check matrix of the base graph is greater than Zc. Here, the quantity of punctured columns of the parity-check matrix of the base graph refers to a quantity of columns corresponding to a parity-check matrix portion of the base graph after lifting.

In this embodiment of this application, each column in the matrix of the base graph corresponds to Zc columns after lifting. For example, puncturing one column in the base graph is equivalent to puncturing Zc columns in the core parity-check matrix after lifting. Puncturing two columns in the base graph is equivalent to puncturing 2*Zc columns in the parity-check matrix after lifting.

Generally, for the LDPC coding scheme, the retransmission sequence of a codeword is as follows: A redundancy version (redundancy version, RV) 0 is sent during initial transmission, an RV 2 is sent during first retransmission, an RV 1 is sent during second retransmission, and an RV 3 is sent during third retransmission. However, in the high throughput scenarios, due to the use of a new base graph and a new puncturing scheme, retransmission cannot follow the sequence of RV0, RV2, RV1, and RV3. Instead, retransmission needs to be performed in a sequence of RV0, RV1, RV2, and RV3 to ensure that the receiver can perform decoding properly.

In this embodiment of this application, the codeword may be a codeword sequence obtained after channel encoding is performed on a message sequence.

### 3. Parameter of the modulation scheme

The modulation scheme may include MLC and BICM. The parameter of the modulation scheme may include one or more of the following: a modulation order, a code rate, and frequency utilization efficiency.

In an example, the modulation scheme may be determined based on a carrier frequency of data. For example, if the carrier frequency of the data is greater than a preset frequency, MLC may be used; if the carrier frequency of the data is less than the preset frequency, BICM may be used; if the carrier frequency of the data is equal to the preset frequency, either MLC or BICM may be used.

In a possible implementation, the transmitter may determine the parameter of the modulation scheme for the physical channel based on the third preset mapping relationship. The third preset mapping relationship may include index values of a plurality of modulation schemes and corresponding modulation parameters.

In an example, to support the high throughput scenarios, the third preset mapping relationship may include a first index value and a corresponding modulation parameter. The modulation parameter corresponding to the first index value is a modulation parameter that supports the high throughput scenarios. For example, among the modulation parameter corresponding to the first index value, the modulation order may be 6, the code rate may be 973, and the frequency utilization efficiency may be 5.7012. The actual code rate may be 973/1024.

### 4. Code length parameter

The code length parameter may include a maximum coding length and a minimum coding length. The maximum coding parameter may be the maximum length of an encoded information bit or the maximum length of an information bit before encoding. The minimum coding length may be the minimum coding length of an encoded information bit or the minimum length of an information bit before encoding.

In some examples, for the polar coding scheme, the maximum coding length may be a maximum length Nmax of the encoded information bit. Nmax may be specified by a polarization exponent (nmax). The relationship between Nmax and nmax may be a power of 2. That is, Nmax=2^{nmax}. For example, if Nmax=1024, then nmax=10.

In some other examples, for the LDPC coding scheme, the maximum coding length may be a maximum length Kmax of an information bit. Kmax may be determined based on a maximum information column quantity Kb of the base graph and/or a maximum lifting factor Zc of a matrix of the base graph. For example, Kmax may be the product of Kb and Zc.

For example, if Kb=22 and Zc=384 in the base graph 1, then a maximum coding length Kmax corresponding to the base graph 1 is 8448. For another example, if Kb=10 and Zc=384 in the base graph 2, then the maximum coding length Kmax corresponding to the base graph 2 is 3840.

In some examples, for the polar coding scheme, the minimum coding length is a minimum length Nmin after encoding. Nmin may be specified by a polarization exponent nmin. The relationship between Nmin and nmin is a power of 2. That is, Nmin=2^{nmin}. For example, if Nmin=32, then nmin=5.

In some other examples, for LDPC coding, the minimum coding length may also be a minimum length Kmin of an information bit. Kmin may be determined based on a minimum information column quantity Kb and/or a minimum lifting factor Zc of the matrix. For example, Kmin may be the product of Kb and Zc. For example, if Kb=11 and Zc=384 in the base graph 1, then the minimum coding length Kmin corresponding to the base graph 1 is 4224. For another example, if Kb=6 and Zc=384 in the base graph 2, then the minimum code length Kmin corresponding to the base graph 2 may be 2304.

### 5. Retransmission parameter

The retransmission parameter may be a quantity of retransmission times of a codeword for data transmission. The retransmission parameter may include a maximum retransmission parameter and a corresponding retransmission start point. For example, the maximum retransmission parameter may be 4, that is, initial transmission is performed once, and retransmission is performed three times. A retransmission start point K0 may be used to determine different retransmission start points based on the conventional technology (for example, a table 5.4.2.1-1 in the 5G standard 38.212).

### 6. Interleaver parameter

The interleaver parameter may include an indicator indicating whether to perform an interleaving operation.

An interleaver may be a row-column interleaver in the conventional technology (for details, refer to section 5.4.2.2 in 38.212 in the 5G standard).

In a possible implementation, hardware implementation of the row-column interleaver imposes a large limitation on throughput improvement. Therefore, to improve throughput efficiency in the high throughput scenarios, the transmitter and the receiver may not perform row-column interleaving on a codeword of data.

In another possible implementation, when the transmitter performs the interleaving operation on the data, the transmitter may further send, to the receiver, indication information indicating the interleaver used to perform the interleaving operation. Based on the indication information, the receiver may perform a de-interleaving operation after demodulating the received data.

In some embodiments, the channel coding scheme for the physical channel is the LDPC coding scheme, and the method provided in this embodiment of this application may further include: The transmitter sends first indication information.

Correspondingly, the receiver receives the first indication information from the transmitter.

The first indication information may indicate to remove an edge of a base graph. The base graph may be the base graph 1. The first indication information may include a row number and a column number in the base graph.

In other words, the first indication information is used to remove an edge corresponding to the row number and the column number. For example, if the first indication information may include {(16, 11), (16, 38), (17, 17), (18, 19)}, the indication information may indicate to remove an edge in an 11^{th} column of a 16^{th} row, a 36^{th} column of the 16^{th} row, a 17^{th} column of a 17^{th} row, and a 19^{th} column of an 18^{th} row in the base graph.

Further, the first indication information may further indicate a base graph from which an edge needs to be removed. For example, the first indication information may include an identifier or an index value of the base graph.

In an example, the base graph, indicated by the first indication information, from which the edge needs to be removed may be shown in Table 10. Table 10 may include 30 row indexes (row index), and each row includes a plurality of column indexes (column index).

**Table 10**

| HBG | | Vi, j | | | | | | | | HBG | | HBG | | | | | | | |
|---|---|---|---|---|---|---|---|---|---|---|---|---|---|---|---|---|---|---|---|
| Row Index i | Column Index j | Setindex | | | | | | | | Row Index i | Column Index j | Setindex | | | | | | | |
| | | 0 | 1 | 2 | 3 | 4 | 5 | 6 | 7 | | | 0 | 1 | 2 | 3 | 4 | 5 | 6 | 7 |
| | 0 | 250 | 307 | 73 | 223 | 211 | 294 | 0 | 135 | 15 | 1 | 96 | 2 | 290 | 120 | 0 | 348 | 6 | 138 |
| | 1 | 69 | 19 | 15 | 16 | 198 | 118 | 0 | 227 | | 10 | 65 | 210 | 60 | 131 | 183 | 15 | 81 | 220 |
| | 2 | 226 | 50 | 103 | 94 | 188 | 167 | 0 | 126 | | 13 | 63 | 318 | 130 | 209 | 108 | 81 | 182 | 173 |
| | 3 | 159 | 369 | 49 | 91 | 186 | 330 | 0 | 134 | | 18 | 75 | 55 | 184 | 209 | 68 | 176 | 53 | 142 |
| | 5 | 100 | 181 | 240 | 74 | 219 | 207 | 0 | 84 | | 25 | 179 | 269 | 51 | 81 | 64 | 113 | 46 | 49 |
| | 6 | 10 | 216 | 39 | 10 | 4 | 165 | 0 | 83 | | 37 | 0 | 0 | 0 | 0 | 0 | 0 | 0 | 0 |
| | 9 | 59 | 317 | 15 | 0 | 29 | 243 | 0 | 53 | 16 | 1 | 64 | 13 | 69 | 154 | 270 | 190 | 88 | 78 |
| 0 | 10 | 229 | 288 | 162 | 205 | 144 | 250 | 0 | 225 | | 3 | 49 | 338 | 140 | 164 | 13 | 293 | 198 | 152 |
| | 11 | 110 | 109 | 215 | 216 | 116 | 1 | 0 | 205 | | 11 | 49 | 57 | 45 | 43 | 99 | 332 | 160 | 84 |
| | 12 | 191 | 17 | 164 | 21 | 216 | 339 | 0 | 128 | | 20 | 51 | 289 | 115 | 189 | 54 | 331 | 122 | 5 |
| | 13 | 9 | 357 | 133 | 215 | 115 | 201 | 0 | 75 | | 22 | 154 | 57 | 300 | 101 | 0 | 114 | 182 | 205 |
| | 15 | 195 | 215 | 298 | 14 | 233 | 53 | 0 | 135 | | 38 | 0 | 0 | 0 | 0 | 0 | 0 | 0 | 0 |
| | 16 | 23 | 106 | 110 | 70 | 144 | 347 | 0 | 217 | 17 | 0 | 7 | 260 | 257 | 56 | 153 | 110 | 91 | 183 |
| | 18 | 190 | 242 | 113 | 141 | 95 | 304 | 0 | 220 | | 14 | 164 | 303 | 147 | 110 | 137 | 228 | 184 | 112 |
| | 19 | 35 | 180 | 16 | 198 | 216 | 167 | 0 | 90 | | 16 | 59 | 81 | 128 | 200 | 0 | 247 | 30 | 106 |
| | 20 | 239 | 330 | 189 | 104 | 73 | 47 | 0 | 105 | | 17 | 1 | 358 | 51 | 63 | 0 | 116 | 3 | 219 |
| | 21 | 31 | 346 | 32 | 81 | 261 | 188 | 0 | 137 | | 21 | 144 | 375 | 228 | 4 | 162 | 190 | 155 | 129 |
| | 22 | 1 | 1 | 1 | 1 | 1 | 1 | 0 | 1 | | 39 | 0 | 0 | 0 | 0 | 0 | 0 | 0 | 0 |
| | 23 | 0 | 0 | 0 | 0 | 0 | 0 | 0 | 0 | 18 | 1 | 42 | 130 | 260 | 199 | 161 | 47 | 1 | 183 |
| | 0 | 250 | 307 | 73 | 223 | 211 | 294 | 0 | 135 | | 12 | 233 | 163 | 294 | 110 | 151 | 286 | 41 | 215 |
| 1 | 0 | 2 | 76 | 303 | 141 | 179 | 77 | 22 | 96 | | 13 | 8 | 280 | 291 | 200 | 0 | 246 | 167 | 180 |
| | 2 | 239 | 76 | 294 | 45 | 162 | 225 | 11 | 236 | | 18 | 155 | 132 | 141 | 143 | 241 | 181 | 68 | 143 |
| | 3 | 117 | 73 | 27 | 151 | 223 | 96 | 124 | 136 | | 19 | 147 | 4 | 295 | 186 | 144 | 73 | 148 | 14 |
| | 4 | 124 | 288 | 261 | 46 | 256 | 338 | 0 | 221 | | 40 | 0 | 0 | 0 | 0 | 0 | 0 | 0 | 0 |
| | 5 | 71 | 144 | 161 | 119 | 160 | 268 | 10 | 128 | 19 | 0 | 60 | 145 | 64 | 8 | 0 | 87 | 12 | 179 |
| | 7 | 222 | 331 | 133 | 157 | 76 | 112 | 0 | 92 | | 1 | 73 | 213 | 181 | 6 | 0 | 110 | 6 | 108 |
| | 8 | 104 | 331 | 4 | 133 | 202 | 302 | 0 | 172 | | 7 | 72 | 344 | 101 | 103 | 118 | 147 | 166 | 159 |
| | 9 | 173 | 178 | 80 | 87 | 117 | 50 | 2 | 56 | | 8 | 127 | 242 | 270 | 198 | 144 | 258 | 184 | 138 |
| | 11 | 220 | 295 | 129 | 206 | 109 | 167 | 16 | 11 | | 10 | 224 | 197 | 41 | 8 | 0 | 204 | 191 | 196 |
| | 12 | 102 | 342 | 300 | 93 | 15 | 253 | 60 | 189 | | 41 | 0 | 0 | 0 | 0 | 0 | 0 | 0 | 0 |
| | 14 | 109 | 217 | 76 | 79 | 72 | 334 | 0 | 95 | 20 | 0 | 151 | 187 | 301 | 105 | 265 | 89 | 6 | 77 |
| | 15 | 132 | 99 | 266 | 9 | 152 | 242 | 6 | 85 | | 3 | 186 | 206 | 162 | 210 | 81 | 65 | 12 | 187 |
| | 16 | 142 | 354 | 72 | 118 | 158 | 257 | 30 | 153 | | 9 | 217 | 264 | 40 | 121 | 90 | 155 | 15 | 203 |
| | 17 | 155 | 114 | 83 | 194 | 147 | 133 | 0 | 87 | | 11 | 47 | 341 | 130 | 214 | 144 | 244 | 5 | 167 |
| | 19 | 255 | 331 | 260 | 31 | 156 | 9 | 168 | 163 | | 22 | 160 | 59 | 10 | 183 | 228 | 30 | 30 | 130 |
| | 21 | 28 | 112 | 301 | 187 | 119 | 302 | 31 | 216 | | 42 | 0 | 0 | 0 | 0 | 0 | 0 | 0 | 0 |
| | 22 | 0 | 0 | 0 | 0 | 0 | 0 | 105 | 0 | 21 | 1 | 249 | 205 | 79 | 192 | 64 | 162 | 6 | 197 |
| | 23 | 0 | 0 | 0 | 0 | 0 | 0 | 0 | 0 | | 5 | 121 | 102 | 175 | 131 | 46 | 264 | 86 | 122 |
| | 24 | 0 | 0 | 0 | 0 | 0 | 0 | 0 | 0 | | 16 | 109 | 328 | 132 | 220 | 266 | 346 | 96 | 215 |
| 2 | 0 | 106 | 205 | 68 | 207 | 258 | 226 | 132 | 189 | | 20 | 131 | 213 | 283 | 50 | 9 | 143 | 42 | 65 |
| | 1 | 111 | 250 | 7 | 203 | 167 | 35 | 37 | 4 | | 21 | 171 | 97 | 103 | 106 | 18 | 109 | 199 | 216 |
| | 2 | 185 | 328 | 80 | 31 | 220 | 213 | 21 | 225 | | 43 | 0 | 0 | 0 | 0 | 0 | 0 | 0 | 0 |
| | 4 | 63 | 332 | 280 | 176 | 133 | 302 | 180 | 151 | 22 | 0 | 64 | 30 | 177 | 53 | 72 | 280 | 44 | 25 |
| | 5 | 117 | 256 | 38 | 180 | 243 | 111 | 4 | 236 | | 12 | 142 | 11 | 20 | 0 | 189 | 157 | 58 | 47 |
| | 6 | 93 | 161 | 227 | 186 | 202 | 265 | 149 | 117 | | 13 | 188 | 233 | 55 | 3 | 72 | 236 | 130 | 126 |
| | 7 | 229 | 267 | 202 | 95 | 218 | 128 | 48 | 179 | | 17 | 158 | 22 | 316 | 148 | 257 | 113 | 131 | 178 |
| | 8 | 177 | 160 | 200 | 153 | 63 | 237 | 38 | 92 | | 44 | 0 | 0 | 0 | 0 | 0 | 0 | 0 | 0 |
| | 9 | 95 | 63 | 71 | 177 | 0 | 294 | 122 | 24 | 23 | 1 | 156 | 24 | 249 | 88 | 180 | 18 | 45 | 185 |
| | 10 | 39 | 129 | 106 | 70 | 3 | 127 | 195 | 68 | | 2 | 147 | 89 | 50 | 203 | 0 | 6 | 18 | 127 |
| | 13 | 142 | 200 | 295 | 77 | 74 | 110 | 155 | 6 | | 10 | 170 | 61 | 133 | 168 | 0 | 181 | 132 | 117 |
| | 14 | 225 | 88 | 283 | 214 | 229 | 286 | 28 | 101 | | 18 | 152 | 27 | 105 | 122 | 165 | 304 | 100 | 199 |
| | 15 | 225 | 53 | 301 | 77 | 0 | 125 | 85 | 33 | | 45 | 0 | 0 | 0 | 0 | 0 | 0 | 0 | 0 |
| | 17 | 245 | 131 | 184 | 198 | 216 | 131 | 47 | 96 | 24 | 0 | 112 | 298 | 289 | 49 | 236 | 38 | 9 | 32 |
| | 18 | 205 | 240 | 246 | 117 | 269 | 163 | 179 | 125 | | 3 | 86 | 158 | 280 | 157 | 199 | 170 | 125 | 178 |
| | 19 | 251 | 205 | 230 | 223 | 200 | 210 | 42 | 67 | | 4 | 236 | 235 | 110 | 64 | 0 | 249 | 191 | 2 |
| | 20 | 117 | 13 | 276 | 90 | 234 | 7 | 66 | 230 | | 11 | 116 | 339 | 187 | 193 | 266 | 288 | 28 | 156 |
| | 24 | 0 | 0 | 0 | 0 | 0 | 0 | 0 | 0 | | 22 | 222 | 234 | 281 | 124 | 0 | 194 | 6 | 58 |
| | 25 | 0 | 0 | 0 | 0 | 0 | 0 | 0 | 0 | | 46 | 0 | 0 | 0 | 0 | 0 | 0 | 0 | 0 |
| 3 | 0 | 121 | 276 | 220 | 201 | 187 | 97 | 4 | 128 | 25 | 1 | 23 | 72 | 172 | 1 | 205 | 279 | 4 | 27 |
| | 1 | 89 | 87 | 208 | 18 | 145 | 94 | 6 | 23 | | 6 | 136 | 17 | 295 | 166 | 0 | 255 | 74 | 141 |
| | 3 | 84 | 0 | 30 | 165 | 166 | 49 | 33 | 162 | | 7 | 116 | 383 | 96 | 65 | 0 | 111 | 16 | 11 |
| | 4 | 20 | 275 | 197 | 5 | 108 | 279 | 113 | 220 | | 14 | 182 | 312 | 46 | 81 | 183 | 54 | 28 | 181 |
| | 6 | 150 | 199 | 61 | 45 | 82 | 139 | 49 | 43 | | 47 | 0 | 0 | 0 | 0 | 0 | 0 | 0 | 0 |
| | 7 | 131 | 153 | 175 | 142 | 132 | 166 | 21 | 186 | 26 | 0 | 195 | 71 | 270 | 107 | 0 | 325 | 21 | 163 |
| | 8 | 243 | 56 | 79 | 16 | 197 | 91 | 6 | 96 | | 2 | 243 | 81 | 110 | 176 | 0 | 326 | 142 | 131 |
| | 10 | 136 | 132 | 281 | 34 | 41 | 106 | 151 | 1 | | 4 | 215 | 76 | 318 | 212 | 0 | 226 | 192 | 169 |
| | 11 | 86 | 305 | 303 | 155 | 162 | 246 | 83 | 216 | | 15 | 61 | 136 | 67 | 127 | 277 | 99 | 197 | 98 |
| | 12 | 246 | 231 | 253 | 213 | 57 | 345 | 154 | 22 | | 48 | 0 | 0 | 0 | 0 | 0 | 0 | 0 | 0 |
| | 13 | 219 | 341 | 164 | 147 | 36 | 269 | 87 | 24 | 27 | 1 | 25 | 194 | 210 | 208 | 45 | 91 | 98 | 165 |
| | 14 | 211 | 212 | 53 | 69 | 115 | 185 | 5 | 167 | | 6 | 104 | 194 | 29 | 141 | 36 | 326 | 140 | 232 |
| | 16 | 240 | 304 | 44 | 96 | 242 | 249 | 92 | 200 | | 8 | 194 | 101 | 304 | 174 | 72 | 268 | 22 | 9 |
| | 17 | 76 | 300 | 28 | 74 | 165 | 215 | 173 | 32 | | 49 | 0 | 0 | 0 | 0 | 0 | 0 | 0 | 0 |
| | 18 | 244 | 271 | 77 | 99 | 0 | 143 | 120 | 235 | 28 | 0 | 128 | 222 | 11 | 146 | 275 | 102 | 4 | 32 |
| | 20 | 144 | 39 | 319 | 30 | 113 | 121 | 2 | 172 | | 4 | 165 | 19 | 293 | 153 | 0 | 1 | 1 | 43 |
| | 21 | 12 | 357 | 68 | 158 | 108 | 121 | 142 | 219 | | 19 | 181 | 244 | 50 | 217 | 155 | 40 | 40 | 200 |
| | 22 | 1 | 1 | 1 | 1 | 1 | 1 | 0 | 1 | | 21 | 63 | 274 | 234 | 114 | 62 | 167 | 93 | 205 |
| | 25 | 0 | 0 | 0 | 0 | 0 | 0 | 0 | 0 | | 50 | 0 | 0 | 0 | 0 | 0 | 0 | 0 | 0 |
| 4 | 0 | 157 | 332 | 233 | 170 | 246 | 42 | 24 | 64 | 29 | 1 | 86 | 252 | 27 | 150 | 0 | 273 | 92 | 232 |
| | 1 | 102 | 181 | 205 | 10 | 235 | 256 | 204 | 211 | | 14 | 236 | 5 | 308 | 11 | 180 | 104 | 136 | 32 |
| | 26 | 0 | 0 | 0 | 0 | 0 | 0 | 0 | 0 | | 18 | 84 | 147 | 117 | 53 | 0 | 243 | 106 | 118 |
| | 0 | 205 | 195 | 83 | 164 | 261 | 219 | 185 | 2 | | 25 | 6 | 78 | 29 | 68 | 42 | 107 | 6 | 103 |
| 5 | 1 | 236 | 14 | 292 | 59 | 181 | 130 | 100 | 171 | | 51 | 0 | 0 | 0 | 0 | 0 | 0 | 0 | 0 |
| | 3 | 194 | 115 | 50 | 86 | 72 | 251 | 24 | 47 | 30 | 0 | 216 | 159 | 91 | 34 | 0 | 171 | 2 | 170 |
| | 12 | 231 | 166 | 318 | 80 | 283 | 322 | 65 | 143 | | 10 | 73 | 229 | 23 | 130 | 90 | 16 | 88 | 199 |
| | 16 | 28 | 241 | 201 | 182 | 254 | 295 | 207 | 210 | | 13 | 120 | 260 | 105 | 210 | 252 | 95 | 112 | 26 |
| | 21 | 123 | 51 | 267 | 130 | 79 | 258 | 161 | 180 | | 24 | 9 | 90 | 135 | 123 | 173 | 212 | 20 | 105 |

Correspondingly, after receiving the first indication information, the receiver may remove an edge of the base graph 1 based on the first indication information.

Based on this embodiment, the edge of the base graph is removed, so that degree distribution of the base graph can be improved, and the base graph is more suitable for decoding with a low quantity of iterations, thereby improving throughput efficiency.

In some examples, to ensure that the receiver can accurately parse the physical channel in the high throughput scenarios, the transmitter may further send second indication information to the receiver, where the second indication information may indicate a coding parameter of the physical channel. For example, the second indication information may include an indicator indicating a channel coding scheme, a modulation scheme, whether retransmission is supported, and whether row-column interleaving is performed. In this way, the receiver may determine the coding parameter of the physical channel based on the second indication information, and perform channel decoding on the demodulated data based on the coding parameter.

Channel decoding includes one or more of channel decoding based on a channel coding scheme, channel decoding based on a base graph, and demodulation based on a modulation scheme.

In a possible implementation, the second indication information may be newly added signaling in control information (for example, DCI) of the physical channel. For example, a structure of the newly added signaling may be shown in FIG. 6. In FIG. 6, a retransmission request may include an automatic repeat request (automatic repeat request, ARQ) and a hybrid automatic repeat request (hybrid automatic repeat quest, HARQ), where intl indicates an interleaver (Interleaver, intl), wo indicates not in use, and new_intl indicates using a new interleaver.

The new interleaver may divide a to-be-interleaved sequence of a codeword into X parts, where 0<X<=Qm, Qm is a higher-order modulation order, and Qm is a positive integer. Each of the X parts may occupy more than 1 bit in any QAM symbol. The new interleaver can greatly simplify interleaving without performance loss, and reduce read/write bandwidth of storage.

In some other examples, the receiver may further determine the channel coding scheme for the physical channel based on a code length of demodulated data. For details, refer to related descriptions of determining the channel coding scheme for the physical channel by the transmitter. Details are not described herein again.

The solutions in the foregoing embodiments of this application may be combined without a conflict.

Actions of the transmitter in S401 and S402 may be performed by the processor 301 in the communication apparatus 300 shown in FIG. 3 by invoking application code stored in the memory 304, to indicate the communication apparatus 300 to perform the actions. Actions of the receiver in S401 and S402 may be performed by the processor 301 in the communication apparatus 300 shown in FIG. 3 by invoking the application code stored in the memory 304, to indicate the communication apparatus 300 to perform the actions. This is not limited in embodiments of this application.

The foregoing mainly describes the solutions provided in embodiments of this application from a perspective of interaction between network elements. Correspondingly, an embodiment of this application further provides a communication apparatus, and the communication apparatus is configured to implement the foregoing methods. The communication apparatus may be the transmitter in the foregoing method embodiments, or may be a component that can be used for the transmitter. Alternatively, the communication apparatus may be the receiver in the foregoing method embodiments, or may be a component that can be used for the receiver. It may be understood that, to implement the foregoing functions, the communication apparatus includes a hardware structure and/or a software module for performing a corresponding function. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the communication apparatus may be divided into functional modules based on the foregoing method embodiments. For example, each functional module may be obtained through division based on each corresponding function, or two or more functions may be integrated into one processing module. The integrated module may be implemented in a form of hardware, or may be implemented in a form of a software functional module. It should be understood that module division in embodiments of this application is an example, and is only logical function division. During actual implementation, there may be another division manner.

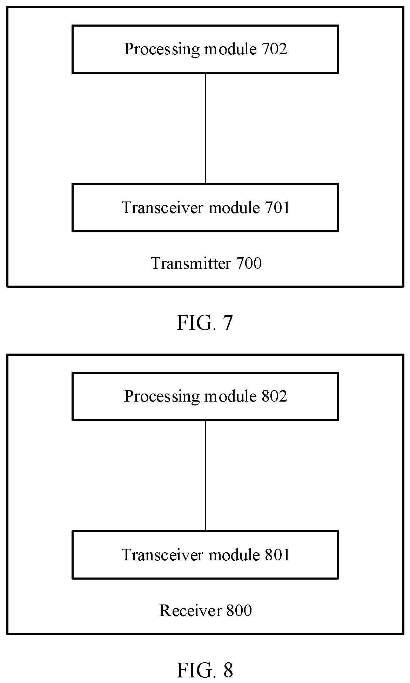

For example, the communication apparatus is the transmitter in the foregoing method embodiments. FIG. 7 is a diagram of a structure of a transmitter 700. The transmitter 700 includes a transceiver module 701 and a processing module 702. The transceiver module 701 may also be referred to as a transceiver unit, and is configured to implement a transceiver function. For example, the transceiver module 701 may be a transceiver circuit, a transceiver machine, a transceiver, or a communication interface.

The processing module 702 is configured to determine a physical channel in a first scenario. A throughput of the first scenario is greater than a preset threshold. The transceiver module 701 is further configured to transmit data using a single codeword when a quantity of transmission layers of the physical channel is greater than a preset quantity of layers.

The transceiver module 701 may be configured to implement a transceiver function corresponding to the transmitter in the foregoing method embodiments, and the processing module 702 may be configured to implement a processing function corresponding to the transmitter in the foregoing method embodiments. Therefore, all related content of the steps in the foregoing method embodiments may be cited in function descriptions of corresponding functional modules, and details are not described herein again.

In this embodiment of this application, the transmitter 700 is presented in a form of functional modules obtained through division in an integrated manner. The "module" herein may be a specific ASIC, a circuit, a processor that executes one or more software or firmware programs, a memory, an integrated logic circuit, and/or another component capable of providing the foregoing functions. In a simple embodiment, a person skilled in the art may figure out that the transmitter 700 may be in a form of the communication apparatus 300 shown in FIG. 3.

For example, the processor 301 in the communication apparatus 300 shown in FIG. 3 may invoke computer-executable instructions stored in a memory 304, so that the communication apparatus 300 performs the communication method in the foregoing method embodiments.

Specifically, a function/an implementation process of the transceiver module 701 and the processing module 702 in FIG. 7 may be implemented by the processor 301 in the communication apparatus 300 shown in FIG. 3 by invoking the computer-executable instructions stored in the memory 304. Alternatively, a function/an implementation process of the processing module 702 in FIG. 7 may be implemented by the processor 301 in the communication apparatus 300 shown in FIG. 3 by invoking the computer-executable instructions stored in the memory 304, and a function/an implementation process of the transceiver module 701 in FIG. 7 may be implemented through a communication interface 302 in the communication apparatus 300 shown in FIG. 3.

The transmitter 700 provided in this embodiment of this application may perform the foregoing communication method. Therefore, for technical effect that can be implemented by the transmitter 700, refer to the foregoing method embodiments. Details are not described herein again.

Alternatively, for example, the communication apparatus is the receiver in the foregoing method embodiments. FIG. 8 is a diagram of a structure of a receiver 800. The receiver 800 includes a transceiver module 801 and a processing module 802. The transceiver module 801 may also be referred to as a transceiver unit, and is configured to implement a transceiver function. For example, the transceiver module 801 may be a transceiver circuit, a transceiver machine, a transceiver, or a communication interface.

The transceiver module 801 is configured to receive data from a transmitter, where the data is transmitted using a single codeword.

The transceiver module 801 may be configured to implement a transceiver function corresponding to the receiver in the foregoing method embodiments, and the processing module 802 may be configured to implement a processing function corresponding to the receiver in the foregoing method embodiments. Therefore, all related content of the steps in the foregoing method embodiments may be cited in function descriptions of corresponding functional modules, and details are not described herein again.

In this embodiment of this application, the receiver 800 is presented in a form of functional modules obtained through division in an integrated manner. The "module" herein may be a specific ASIC, a circuit, a processor that executes one or more software or firmware programs, a memory, an integrated logic circuit, and/or another component capable of providing the foregoing functions. In a simple embodiment, a person skilled in the art may figure out that the receiver 800 may be in a form of the communication apparatus 300 shown in FIG. 3.

For example, the processor 301 in the communication apparatus 300 shown in FIG. 3 may invoke computer-executable instructions stored in the memory 304, so that the communication apparatus 300 performs the communication method in the foregoing method embodiments.

Specifically, a function/an implementation process of the transceiver module 801 and the processing module 802 in FIG. 8 may be implemented by the processor 301 in the communication apparatus 300 shown in FIG. 3 by invoking the computer-executable instructions stored in the memory 304. Alternatively, a function/an implementation process of the processing module 802 in FIG. 8 may be implemented by the processor 301 in the communication apparatus 300 shown in FIG. 3 by invoking the computer-executable instructions stored in the memory 304, and a function/an implementation process of the transceiver module 801 in FIG. 8 may be implemented through a communication interface 302 in the communication apparatus 300 shown in FIG. 3.

The receiver 800 provided in this embodiment may perform the foregoing communication method. Therefore, for technical effect that can be implemented by the receiver 800, refer to the foregoing method embodiments. Details are not described herein again.

It should be understood that one or more of the modules or units may be implemented by software, hardware, or a combination thereof. When any one of the foregoing modules or units is implemented by using software, the software exists in a form of computer program instructions, and is stored in a memory. A processor may be configured to execute the program instructions and implement the foregoing method procedures. The processor may be built into an SoC (system on a chip) or an ASIC, or may be an independent semiconductor chip. In addition to a core used to execute software instructions to perform an operation or processing, the processor may further include a necessary hardware accelerator, for example, a field programmable gate array (field programmable gate array, FPGA), a PLD (programmable logic device), or a logic circuit that implements a dedicated logic operation.

When the foregoing modules or units are implemented by hardware, the hardware may be any one or any combination of a CPU, a microprocessor, a digital signal processing (digital signal processing, DSP) chip, a microcontroller unit (microcontroller unit, MCU), an artificial intelligence processor, an ASIC, an SoC, an FPGA, a PLD, a dedicated digital circuit, a hardware accelerator, or a non-integrated discrete device, and the hardware may run necessary software or may perform the foregoing method procedure without relying on software.

Optionally, an embodiment of this application further provides a communication apparatus (for example, the communication apparatus may be a chip or a chip system). The communication apparatus includes a processor, configured to implement the method in any one of the foregoing method embodiments. In a possible design, the communication apparatus further includes a memory. The memory is configured to store necessary program instructions and necessary data. The processor may invoke program code stored in the memory, to indicate the communication apparatus to perform the method in any one of the foregoing method embodiments. Certainly, the communication apparatus may not include a memory. When the communication apparatus is a chip system, the communication device may include a chip, or may include a chip and another discrete component. This is not specifically limited in embodiments of this application.

In a possible implementation, an embodiment of this application further provides a computer-readable storage medium. The computer-readable storage medium stores a computer program or instructions. When the computer program or the instructions are run on a communication apparatus, the communication apparatus is enabled to perform the method in any one of the foregoing method embodiments or the foregoing implementations.

In a possible implementation, an embodiment of this application further provides a communication system. The communication system includes the transmitter in the foregoing method embodiments and the receiver in the foregoing method embodiments.

In a possible implementation, an embodiment of this application further provides a communication method. The communication method includes the method in any one of the foregoing method embodiments or any implementation of the foregoing method embodiments.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or other programmable apparatuses. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state drive (solid state drive, SSD)), or the like.

Although this application is described with reference to embodiments, in a process of implementing this application that claims protection, a person skilled in the art may understand and implement another variation of the disclosed embodiments by viewing the accompanying drawings, disclosed content, and the accompanying claims. In the claims, "comprising" (comprising) does not exclude another component or another step, and "a" or "one" does not exclude a case of multiple. A single processor or another unit may implement several functions enumerated in the claims. Some measures are recorded in dependent claims that are different from each other, but this does not mean that these measures cannot be combined to produce a better effect.

Although this application is described with reference to specific features and embodiments thereof, it is clear that various modifications and combinations may be made to them without departing from the spirit and scope of this application. Correspondingly, the specification and accompanying drawings are merely example description of this application defined by the accompanying claims, and are considered as any of or all modifications, variations, combinations or equivalents that cover the scope of this application. It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A communication method, applied to a transmitter, wherein the method comprises:
determining a physical channel in a first scenario, wherein a throughput of the first scenario is greater than a preset threshold; and
transmitting data using a single codeword when a quantity of transmission layers of the physical channel is greater than a preset quantity of layers.

2. The method according to claim 1, wherein determining a transport channel for transmitting data comprises:
determining a transport channel for the data; and
determining, according to a first preset mapping relationship, a physical channel corresponding to the transport channel, wherein the first preset mapping relationship comprises a plurality of transport channels and a physical channel corresponding to each transport channel.

3. The method according to claim 2, wherein the physical channel comprises an uplink physical channel and a downlink physical channel, and the first preset mapping relationship comprises a first mapping relationship and a second mapping relationship; and
the first mapping relationship comprises mappings between a plurality of uplink transport channels and a plurality of uplink physical channels, and the second mapping relationship comprises mappings between a plurality of downlink transport channels and a plurality of downlink physical channels.

4. The method according to claim 3, wherein determining a physical channel for transmitting data comprises:
determining control information of the physical channel; and
determining, according to a second preset mapping relationship, a physical channel corresponding to the control information, wherein the second preset mapping relationship comprises a third mapping relationship and a fourth mapping relationship, the third mapping relationship comprises a mapping between uplink control information and the uplink physical channel, and the fourth mapping relationship comprises a mapping between downlink control information and the downlink physical channel.

5. The method according to any one of claims 1 to 4, wherein the preset quantity of layers is 4.

6. The method according to any one of claims 1 to 5, wherein a coding parameter of the physical channel comprises one or more of the following: a parameter of a channel coding scheme for the data and/or the control information, a base graph parameter, a modulation parameter of a modulation scheme, a code length parameter, a retransmission parameter, and an interleaver parameter; and
the channel coding scheme comprises a polar (Polar) coding scheme and a low-density parity-check LDPC coding scheme; the base graph comprises a first base graph and a second base graph, and the first base graph and the second base graph have different core parity-check columns; the modulation scheme comprises multi-layer coding MLC and bit-interleaved coded modulation BICM; the code length parameter comprises a maximum coding length and a minimum coding length; the retransmission parameter comprises a maximum retransmission parameter and a corresponding retransmission start point; and the interleaver parameter comprises an indicator indicating whether to perform bit interleaving.

7. The method according to claim 6, wherein the channel coding scheme is determined based on a code length of the data.

8. The method according to claim 7, wherein
when the code length of the data is less than or equal to a preset code length, the channel coding scheme is the polar coding scheme;
when the code length of the data is greater than the preset code length, the channel coding scheme is the LDPC coding scheme; and
when the code length of the data is equal to the preset code length, the channel coding scheme is the polar coding scheme or the LDPC coding scheme.

9. The method according to claim 6 or 7, wherein a channel coding scheme corresponding to the transport channel for the data comprises the polar coding scheme and the LDPC coding scheme; and a channel coding scheme corresponding to the control information is the polar coding scheme.

10. The method according to any one of claims 6 to 8, wherein a value range of Zc in the LDPC coding scheme is a subset of a preset matrix lifting set or a preset subset.

11. The method according to claim 10, wherein a value in the preset subset is a positive integer multiple of 23, and a largest value in the preset subset is greater than 384.

12. The method according to claim 10 or 11, wherein an element in the preset matrix lifting set is aⱼ×2^{k}ⱼ, wherein aⱼ∈{2, 3, 5, 7, 9, 11, 13, 15}, and kⱼ∈{4, 5, 6, 7}.

13. The method according to any one of claims 6 to 12, wherein the channel coding scheme is the LDPC coding scheme, and the method further comprises:
skipping performing row-column interleaving on a codeword of the data.

14. The method according to claim 6, wherein the base graph parameter comprises a quantity of punctured columns of a core parity-check matrix of the base graph and/or a code rate obtained after column puncturing.

15. The method according to claim 14, wherein a quantity of punctured columns of a core parity-check matrix of the first base graph is greater than 1, a 1^{st} column of the first base graph is not punctured, and a code rate obtained after puncturing is performed on a core parity-check matrix of the second base graph is greater than a preset code rate.

16. The method according to claim 6, 14, or 15, wherein elements in a 1^{st} row of the core parity-check matrix of the second base graph are elements in a 2^{nd} row of the core parity-check matrix of the first base graph, and elements in a 2^{nd} row of the core parity-check matrix of the second base graph are elements in a 1^{st} row of the core parity-check matrix of the first base graph.

17. The method according to any one of claims 6 and 14 to 16, wherein the base graph is the first base graph, and the method further comprises:
sending first indication information, wherein the first indication information indicates to remove an edge of the first base graph, the first indication information comprises a first row number and a first column number, and the edge is an edge corresponding to the first row number and the first column number.

18. The method according to claim 6, wherein the method further comprises:
determining a modulation scheme for the physical channel; and
determining a modulation parameter for the physical channel based on a third preset mapping relationship, wherein the third preset mapping relationship comprises indexes of a plurality of modulation schemes and a modulation parameter corresponding to each index.

19. The method according to claim 18, wherein
when a carrier frequency of the data is greater than a preset frequency, the modulation scheme is MLC;
when the carrier frequency of the data is less than the preset frequency, the modulation scheme is BICM; and
when the carrier frequency of the data is equal to the preset frequency, the modulation scheme is either MLC or BICM.

20. The method according to claim 18 or 19, wherein the parameter of the modulation scheme comprises one or more of the following: a modulation order, a code rate, and spectral efficiency, and for the data, the modulation order is 6, the code rate is 973, and the spectral efficiency is 5.7012.

21. The method according to any one of claims 1 to 20, wherein the method further comprises:
sending second indication information, wherein the second indication information indicates one or more of the following: a channel coding scheme, a modulation scheme, whether retransmission is supported, and whether row-column interleaving is performed.

22. A communication method, applied to a receiver, wherein the method comprises:
receiving data transmitted from a transmitter;
demodulating the data to obtain demodulated data; and
performing channel decoding on the demodulated data to obtain original data.

23. The method according to claim 22, wherein the method further comprises:
determining a coding parameter, wherein the coding parameter comprises one or more of the following: a parameter of a channel coding scheme for the data and/or control information, a base graph parameter, a modulation parameter of a modulation scheme, a code length parameter, a retransmission parameter, and an interleaver parameter; the channel coding scheme comprises a polar (Polar) coding scheme and a low-density parity-check LDPC coding scheme; the base graph comprises a first base graph and a second base graph, and the first base graph and the second base graph have different core parity-check columns; the modulation scheme comprises multi-layer coding MLC and bit-interleaved coded modulation BICM; the code length parameter comprises a maximum coding length and a minimum coding length; the retransmission parameter comprises a maximum retransmission parameter and a corresponding retransmission start point; and the interleaver parameter comprises an indicator indicating whether to perform interleaving; and
performing channel decoding on the demodulated data comprises:
performing channel decoding on the demodulated data based on the coding parameter.

24. The method according to claim 23, wherein the method further comprises:
receiving first indication information from the transmitter, wherein the first indication information indicates to remove an edge of the first base graph, the first indication information comprises a first row number and a first column number, and the edge is an edge corresponding to the first row number and the first column number; and
removing the edge corresponding to the first row number and the first column number from the first base graph.

25. The method according to claim 23 or 24, wherein determining a coding parameter of the physical channel comprises:
receiving second indication information from the transmitter, wherein the second indication information indicates the coding parameter of the physical channel; and
determining the coding parameter of the physical channel based on the second indication information.

26. The method according to any one of claims 22 to 25, wherein the method further comprises:
skipping performing de-interleaving on the demodulated data.

27. A communication apparatus, comprising a module configured to perform the method according to any one of claims 1 to 21, or a module configured to perform the method according to any one of claims 22 to 26.

28. A communication apparatus, wherein the communication apparatus comprises one or more processors and one or more memories, the one or more memories are coupled to the one or more processors, and the one or more memories are configured to store computer program code or computer instructions; and
when the one or more processors execute the computer instructions, the communication apparatus is enabled to perform the method according to any one of claims 1 to 21 or the method according to any one of claims 22 to 26.

29. A computer-readable storage medium, wherein the computer-readable storage medium stores computer instructions or a program, and when the computer instructions or the program are/is run on a computer, the computer is enabled to perform the method according to any one of claims 1 to 21 or the method according to any one of claims 22 to 26.

30. A communication system, comprising a receiver and a transmitter, wherein the transmitter is configured to perform the method according to any one of claims 1 to 21, and the receiver is configured to perform the method according to any one of claims 22 to 26.
